Europäisches Patentamt

European Patent Office

Office européen des brevets

(19)

(11) **EP 0 958 486 B1**

(12) **EUROPÄISCHE PATENTSCHRIFT**

(45) Veröffentlichungstag und Bekanntmachung des Hinweises auf die Patenterteilung:
**03.09.2003 Patentblatt 2003/36**

(51) Int Cl.[7]: **G01C 17/30**, G01C 17/38, G01C 21/20, G01R 33/022

(21) Anmeldenummer: **98908018.9**

(22) Anmeldetag: **30.01.1998**

(86) Internationale Anmeldenummer:
**PCT/EP98/00489**

(87) Internationale Veröffentlichungsnummer:
**WO 98/035205 (13.08.1998 Gazette 1998/32)**

(54) **ANORDNUNG ZUM MESSEN DER RICHTUNG DES ERDMAGNETFELDES**

GEOMAGNETIC FIELD DIRECTION MEASURING SYSTEM

SYSTEME POUR MESURER LE SENS DU CHAMP GEOMAGNETIQUE

(84) Benannte Vertragsstaaten:
**DE FR GB**

(30) Priorität: **10.02.1997 DE 19704956**

(43) Veröffentlichungstag der Anmeldung:
**24.11.1999 Patentblatt 1999/47**

(73) Patentinhaber: **Leica Geosystems AG**
**9435 Heerbrugg (CH)**

(72) Erfinder:
• **GNEPF, Silvio**
**CH-9435 Heerbrugg (CH)**
• **RAMSEIER, Ernst**
**CH-9443 Widnau (CH)**

(74) Vertreter: **Kaminski, Susanne et al**
**Büchel, Kaminski & Partner**
**Patentanwälte Est.**
**Austrasse 79**
**9490 Vaduz (LI)**

(56) Entgegenhaltungen:
**EP-A- 0 145 950          EP-A- 0 387 991**

• **PATENT ABSTRACTS OF JAPAN vol. 009, no. 299 (P-408), 27.November 1985 & JP 60 135814 A (NIPPON DENKI KK), 19.Juli 1985,**
• **WYNN ET AL.: "Advanced superconducting gradiometer/magnetometer arrays and a novel signal processing technique" IEEE TRANSACTIONS ON MAGNETICS., Bd. MAG-11, Nr. 2, März 1975, NEW YORK US, Seiten 701-707, XP002067146**

**Beschreibung**

Die Erfindung betrifft eine Anordnung und ein Verfahren zum Messen der Richtung des Erdmagnetfeldes $\vec{B}_E$ in der Nähe eines magnetischen Störers mit zeitlich veränderlicher Magnetfeldrichtung.

Die Richtung des Erdmagnetfeldes dient in vielen Anwendungen als Referenz für Orientierungen und Navigationen auf und über der Erdoberfläche. Bezugsgröße ist die magnetische Nordrichtung, die als Richtung der Horizontalkomponente des erdmagnetischen Feldes definiert ist. Ein von der Fa. Leica AG, Heerbrugg, Schweiz, entwickeltes Magnetfeld-Meßgerät DMC (Digital Magnetic Compass) bestimmt diese Komponente aus der Messung der Magnetfeldkomponenten in den drei Raumrichtungen und der Messung der Horizontallage.

Bei Einbau des Kompasses in ein elektrisches Gerät wird im allgemeinen die Messung des Erdmagnetfeldes durch Magnetfelder verfälscht, die von magnetischen Geräteteilen oder stromführenden Leitern erzeugt werden. Solange diese Störer zeitlich konstant oder nur langsam veränderlich sind, können sie durch einmalige oder in größeren Abständen durchzuführende Kalibrierprozeduren kompensiert werden.

So ist aus US 4 539 760 ein Verfahren bekannt, bei dem ein mit einem magnetischen Sensorsystem ausgestattetes Fahrzeug nacheinander in unterschiedliche, vorbestimmte Orientierungen im Raum gebracht wird. Aus den lageabhängigen Meßwerten wird eine 3-D-Korrektur-Matrix zur Kompensation magnetischer Störungen abgeleitet. Das Verfahren setzt zeitlich konstante Störungen voraus.

Aus DE 38 33 798 A1 ist ein Verfahren zur Ermittlung des Störeinflusses von ein- und abschaltbaren Verbrauchern auf Navigationssysteme bekannt. Bei ausgeschalteten Verbrauchern wird zunächst durch Fahrzeugdrehung eine zweidimensionale Ortskurve des Erdmagnetfeldes bestimmt, deren Mittelpunkt um den Vektor des am Magnetfeldsensor vorhandenen hartmagnetischen Störfeldes verschoben ist. Danach wird bei stehendem Fahrzeug die Größe des Störeinflusses von nacheinander eingeschalteten Verbrauchern ermittelt und bei Überschreitung von Grenzwerten zur Korrektur berücksichtigt. Es wird vorausgesetzt, daß die ermittelten Störfelder im eingeschalteten Zustand immer dasselbe hartmagnetische Feld ausstrahlen. Außerdem ist es erforderlich, den momentanen Schaltzustand der Störer zu kennen.

Ist die Störung jedoch schnell veränderlich, so sind die bekannten Methoden zur Kompensation von Störfeldern nicht anwendbar. Ein typisches Beispiel dafür stellt ein Gerät dar, das einen Magneten enthält, der an einer festen Stelle montiert ist, an diesem Ort aber z. B. über eine kardanische Aufhängung in alle Richtungen frei beweglich ist. Ein anderes Beispiel wäre ein Spule, die von einem veränderlichen Strom durchflossen wird.

Der Erfindung lag daher die Aufgabe zugrunde, eine Anordnung und ein Verfahren anzugeben, mit denen eine solche, beliebig schnell veränderliche magnetische Störquelle hinsichtlich ihres Einflusses auf die Messung der Richtung des Erdmagnetfeldes beseitigt werden kann.

Diese Aufgabe wird erfindungsgemäß durch die kennzeichnenden Merkmale der Ansprüche 1 und 2 gelöst. Vorteilhafte Ausgestaltungen ergeben sich aus den Merkmalen der Unteransprüche.

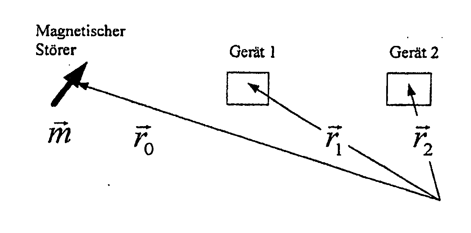

In der Zeichnung ist die Meßanordnung schematisch dargestellt.

Die beiden Magnetfeldmeßgeräte 1 und 2 sind räumlich getrennt, aber starr zueinander und zum magnetischen Störer $\vec{m}$ angeordnet. Zweckmäßigerweise werden die Meßrichtungen der beiden Meßgeräte fluchtend hintereinander oder zumindest parallel zueinander ausgerichtet.

Dies ist jedoch keine zwingende Voraussetzung, denn die Meßwerte können durch geeignete Koordinatentransformation (Drehmatrizen) jederzeit auf eine gemeinsame Richtung umgerechnet werden.

In einem beliebigen Koordinatensystem werden die Ortsvektoren des Störers und der Meßgeräte mit $\vec{r}_0$, $\vec{r}_1$, $\vec{r}_2$ bezeichnet.

Das Feld des Störers in unbekannter Lage mit unbekannter Stärke wird erfindungsgemäß als magnetischer Dipol $\vec{m}$ betrachtet. Die Meßgeräte 1 und 2 werden zweckmäßigerweise so angeordnet, daß der Störer in Verlängerung der von ihnen gebildeten Meßrichtung liegt. Er sollte nicht auf der Mittelebene zwischen den beiden Meßgeräten liegen, da sich bei symmetrischer Lage des Störers zu den Meßgeräten die Meßinformationen gegenseitig aufheben können.

Wird in der dargestellten Anordnung mit zwei in drei Koordinaten messenden Magnetfeldmeßgeräten jeweils das von ihnen detektierte Gesamtfeld $\vec{B}_1$ und $\vec{B}_2$ gemessen, so kann daraus das Erdmagnetfeld $\vec{B}_E$ gemäß

$$\vec{B}_E = (\vec{B}_1 + \vec{B}_2)/2 + P \cdot (\vec{B}_1 - \vec{B}_2)$$

mit

$$P = \begin{pmatrix} P_{11} & P_{21} & P_{31} \\ P_{12} & P_{22} & P_{32} \\ P_{13} & P_{23} & P_{33} \end{pmatrix}$$

bestimmt werden.

Dieser Auswertevorschrift liegt die Überlegung zugrunde, daß das Feld eines magnetischen Dipols $\vec{m}$ am Ort $\vec{r}_0$ sich am Ort $\vec{r}$ beschreiben läßt durch

$$\vec{B}_{Dip}(\vec{r},\vec{r}_0) = P(\vec{r}, \vec{r}_0) \cdot \vec{m}$$

mit

$$P(\vec{r},\vec{r}_0) = \frac{3 \cdot \vec{d} \cdot \vec{d}^T - \vec{d}^T \, \vec{d} I_3}{d^5}$$

wobei

$$\vec{d} = \vec{r} - \vec{r}_0 \quad ; d = |\vec{d}| \quad \text{und} \quad I_3 = \begin{pmatrix} 1 & 0 & 0 \\ 0 & 1 & 0 \\ 0 & 0 & 1 \end{pmatrix}$$

Damit ergibt sich für das durch die Meßgeräte 1 und 2 an den Orten $\vec{r}_1$ und $\vec{r}_2$ gemessene Gesamtmagnetfeld

$$\vec{B}_1 = \vec{B}_E + P_1 \cdot \vec{m} \text{ mit } P_1 = P(\vec{r}_1, \vec{r}_0)$$

$$\vec{B}_2 = \vec{B}_E + P_2 \cdot \vec{m} \text{ mit } P_2 = P(\vec{r}_2, \vec{r}_0)$$

woraus sich für $\vec{B}_E$ die oben angegebene Auswertevorschrift

$$\vec{B}_E = (\vec{B}_1 + \vec{B}_2)/2 + P \cdot (\vec{B}_1 - \vec{B}_2) \text{ mit } P = -\frac{1}{2}(P_1 + P_2)(P_1 - P_2)^{-1}$$

ableitet.

Es ist dabei unbeachtlich, in welcher Lage sich der fragliche Dipol gerade befindet und welche Stärke er momentan hat. Solange die beiden Meßgeräte exakt synchron arbeiten, ist es auch unbeachtlich, ob sich der Dipol während der Messung verdreht oder sonstwie verändert. Wichtig ist lediglich, daß beide Meßgeräte während der gesamten Meßzeit aus unveränderter relativer Lage zueinander dem Einfluß desselben Dipols ausgesetzt sind.

Da die symmetrische Matrix P von den Ortskoordinaten des Störers und der beiden Meßgeräte abhängt, lassen sich die Matrixelemente im allgemeinen aus den bekannten Konstruktionsdaten leicht bestimmen.

Es ist jedoch auch möglich, die Matrix experimentell zu bestimmen. Dazu ist das Gerät, das den veränderlichen Dipol enthält, in eine feste Lage zu bringen, in der das Erdmagnetfeld $\vec{B}_E$ konstant bleibt. Die magnetische Störgröße (Dipol) wird in viele, möglichst unterschiedliche Zustände gebracht. In jeder der Lagen werden die Magnetfelder $\vec{B}_1$ und $\vec{B}_2$ gemessen und in die obige Bestimmungsgleichung eingesetzt, welche dann mit einem beliebigen, an sich bekannten Verfahren zur Lösung linearer Gleichungen nach den unbekannten Matrixelementen $P_{11} \dots P_{33}$ und $\vec{B}_E$ aufgelöst wird. Ein solches Vorgehen ist insbesondere dann vorteilhaft, wenn sich zusätzlich noch weichmagnetische Materialien im System befinden, welche die Störfelder des veränderlichen Störers verzerren. Die Matrix P wird dann im allgemeinen nicht mehr symmetrisch sein, wie bei der obigen Betrachtung noch angenommen wurde.

Die erfindungsgemäße Anordnung dient in erster Linie dazu, die Richtung des Erdmagnetfeldes unter dem Einfluß eines Dipolvektors bekannten Ortes jederzeit korrekt bestimmen zu können. Sie kann jedoch ersichtlich auch dazu verwendet werden, einen Dipolvektor $\vec{m}$ unbekannten Ortes $\vec{r}_0$ nach Richtung und Länge zu bestimmen, indem aus den oben aufgeführten Bestimmungsgleichungen anstelle des Erdmagnetfeldes $\vec{B}_E$ der Dipolvektor $\vec{m}$ berechnet wird.

Die beschriebene Anordnung kann auch in der Weise erweitert werden, daß mehr als zwei Meßgeräte in analoger Anordnung vorgesehen werden. Damit können zusätzlich für einen zweiten oder weitere Störer bekannten Ortes oder in analoger Weise zum obigen Abschnitt für weitere Störer unbekannten Ortes ihr Einfluß auf die Messung des Erdmagnetfeldes $\vec{B}_E$ beseitigt werden oder entsprechend ihre Dipolvektoren $\vec{m}_k$ und Orte $\vec{r}_k$ in systematischer Erweiterung der oben angegebenen Verfahren.

Die synchrone Messung aller Meßgeräte ist jedoch weiterhin Voraussetzung.

Eine Lagebestimmung des magnetisierten Gerätes kann mittels dreier Meßgeräte vorgenommen werden unter Einhaltung der vorstehend genannten erfindungsgemäßen Bedingungen. Dem zusätzlichen Meßwert ist eine weitere unabhängige Bestimmungsgleichung entsprechend den oben angegebenen Beziehungen zugeordnet. Das erweiterte Gleichungssystem kann mit Hilfe an sich bekannter Verfahren zur numerischen Lösung nichtlinearer Gleichungen für den Parameter $\vec{r}_0$ gelöst werden.

**Patentansprüche**

1. Anordnung zum Messen der Richtung des Erdmagnetfeldes $\vec{B}_E$ in der Nähe eines magnetischen Störers mit zeitlich veränderlicher Magnetfeldrichtung, **dadurch gekennzeichnet, daß** mindestens zwei Magnetfeldmeßgeräte vorgesehen sind, die jeweils alle drei Vektorkomponenten des Gesamtmagnetfeldes $\vec{B}_1$, $\vec{B}_2$ messen, die Magnetfeldmeßgeräte eine feste, zeitlich unveränderliche Lage $\vec{r}_0$, $\vec{r}_1$, $\vec{r}_2$ zueinander und zum Störer aufweisen, die Meßwerte zeitsynchron abrufbar sind und entsprechend $\vec{B}_E = (\vec{B}_1 + \vec{B}_2)/2 + P \cdot (\vec{B}_1 - \vec{B}_2)$ auswertbar sind, wobei $P(\vec{r}_0, \vec{r}_1, \vec{r}_2)$ die geometrische Lage der Magnetfeldmeßgeräte zueinander und zum Störer beschreibt.

2. Verfahren zum Messen der Richtung des Erdmagnetfeldes $\vec{B}_E$ in der Nähe eines magnetischen Störers mit zeitlich veränderlicher Magnetfeldrichtung, **dadurch gekennzeichnet, daß** mit mindestens zwei in fester räumlicher Anordnung zueinander und zum Störer angeordneten Magnetfeldmeßgeräten jeweils die drei Vektorkomponenten des Gesamtmagnetfeldes $\vec{B}_1$, $\vec{B}_2$ zeitsynchron gemessen und entsprechend $\vec{B}_E = (\vec{B}_1 + \vec{B}_2)/2 + P \cdot (\vec{B}_1 - \vec{B}_2)$ ausgewertet werden, wobei $P(\vec{r}_0, \vec{r}_1, \vec{r}_2)$ eine die geometrische Lage der Magnetfeldmeßgeräte zueinander und zu dem Störer beschreibende Matrix ist.

3. Verfahren nach Anspruch 2, **dadurch gekennzeichnet, daß** die Matrix P aus bekannten Konstruktionsdaten bestimmt wird.

4. Verfahren nach Anspruch 2, **dadurch gekennzeichnet, daß** die Matrix P durch Messung ermittelt wird, indem das Gesamtgerät in fester räumlicher Lage gehalten und der Störer in möglichst viele unterschiedliche Zustände gebracht wird, in denen die Gesamtmagnetfelder gemessen und daraus ein System linearer Bestimmungsgleichungen gebildet wird.

**Claims**

1. System for measuring the direction of the geomagnetic field $\vec{B}_E$ in the vicinity of a stray magnetic field having a magnetic field direction which varies as a function of time, **characterized in that** at least two magnetic field measuring instruments are provided, each of which measures all three vector components of the total magnetic field $\vec{B}_1$, $\vec{B}_2$, the magnetic field measuring instruments have a fixed position $\vec{B}_0$, $\vec{B}_1$, $\vec{B}_2$ relative to one another and to the stray field, which position is invariable as a function of time, the measured values can be called up synchronously and can be evaluated according to $\vec{B}_E = (\vec{B}_1 + \vec{B}_2)/2 + P \cdot (\vec{B}_1 - \vec{B}_2)$, $P(\vec{r}_0, \vec{r}_1, \vec{r}_2)$ describing the geometrical position of the magnetic field measuring instruments relative to one another and to the stray field.

2. Method for measuring the direction of the geomagnetic field $\vec{B}_E$ in the vicinity of a stray magnetic field having a magnetic field direction which varies as a function of time, **characterized in that** in each case the three vector components of the total magnetic field $\vec{B}_1$, $\vec{B}_2$ are measured synchronously by means of at least two magnetic field measuring instruments arranged in a fixed three-dimensional arrangement relative to one another and to the stray field and are evaluated according to $\vec{B}_E = (\vec{B}_1 + \vec{B}_2)/2 + P \cdot (\vec{B}_1 - \vec{B}_2)$, $P(\vec{r}_0, \vec{r}_1, \vec{r}_2)$ being the geometrical

position of the magnetic field measuring instruments relative to one another and to the matrix describing the stray field.

3. Method according to Claim 2, **characterized in that** the matrix P is determined from known construction data.

4. Method according to Claim 2, **characterized in that** the matrix P is determined by measurement, by keeping the total instrument in a fixed three-dimensional position and bringing the stray field into as many different states as possible in which the total magnetic fields are measured and a system of linear conditional equations is formed therefrom.


**Revendications**

1. Dispositif pour mesurer le sens du champ géomagnétique $\vec{B}_E$ à proximité d'un perturbateur magnétique, avec un sens de champ magnétique variant avec le temps, **caractérisé en ce que** l'on prévoit au moins deux appareils de mesure du champ magnétique qui, chacun, mesurent la totalité des trois composantes vectorielles du champ magnétique global $\vec{B}_1, \vec{B}_2$, les appareils de mesure de champ magnétique présentent une position fixe $\vec{r}_0, \vec{r}_1, \vec{r}_2$ invariable en fonction du temps, les uns par rapport aux autres et par rapport au perturbateur,
les valeurs de mesure peuvent être interrogées de façon temporellement synchrone et peuvent être évaluées de manière correspondante à $\vec{B}_E = (\vec{B}_1 + \vec{B}_2)/2 + P \cdot (\vec{B}_1 - \vec{B}_2)$, sachant que $P(\vec{r}_0, \vec{r}_1, \vec{r}_2)$ décrit la position géométrique des appareils de mesure du champ magnétique les uns par rapport aux autres et par rapport au perturbateur.

2. Procédé pour mesurer le sens du champ géomagnétique $\vec{B}_E$ à proximité d'un perturbateur magnétique, avec un sens de champ magnétique temporellement invariable, **caractérisé en ce que**, en utilisant au moins deux appareils de mesure du champ magnétique, disposé en un agencement spatial mutuel fixe, les uns par rapport aux autres et par rapport au perturbateur, chaque fois les trois composantes vectorielles du champ magnétique global $\vec{B}_1, \vec{B}_2$ sont mesurées de façon temporellement synchrone et évaluées de manière correspondante à $\vec{B}_E = (\vec{B}_1 + \vec{B}_2)/2 + P \cdot (\vec{B}_1 - \vec{B}_2)$, sachant que $P(\vec{r}_0, \vec{r}_1, \vec{r}_2)$ est une matrice décrivant la position géométrique des appareils de mesure de champ magnétique, les uns par rapport aux autres et par rapport au perturbateur.

3. Procédé selon la revendication 2, **caractérisé en ce que** la matrice P est déterminée à partir de données de construction connues.

4. Procédé selon la revendication 2, **caractérisé en ce que** la matrice P est déterminée par une mesure, par le fait que l'appareil global est maintenu à une position spatialement fixe et le perturbateur est placé en un nombre maximal possible d'états différents, auxquels les champs magnétiques globaux sont mesurés et, à partir de là, un système d'équations de détermination linéaires étant formé.